# EUROPEAN PATENT SPECIFICATION

(11) **EP 3 225 926 B1**
(45) Date of publication and mention of the grant of the patent: **12.12.2018**
(21) Application number: 17163764.8
(22) Date of filing: 30.03.2017
(51) Int. Cl.: F24F 5/00, F24F 12/00, F24F 3/14, H05K 7/20

(54) **EVAPORATION HEAT EXCHANGE DEVICE FOR AIR COOLING FOR CONDITIONING AND CLIMATE CONTROL SYSTEMS FOR SERVER ROOMS AND THE LIKE**
VERDAMPFUNGS-WÄRMETAUSCHVORRICHTUNG ZUR LUFTKÜHLUNG FÜR KONDITIONIERUNGS- UND KLIMAKONTROLLSYSTEME FÜR SERVERRÄUME UND DERGLEICHEN
DISPOSITIF D'ÉCHANGE DE CHALEUR PAR ÉVAPORATION À REFROIDISSEMENT D'AIR DE SYSTÈMES DE CLIMATISATION ET DE RÉGULATION DE LA TEMPÉRATURE POUR LOCAUX DE SERVEUR ET ANALOGUES

(30) Priority: 01.04.2016 IT UA20162214
(43) Date of publication of application: 04.10.2017
(73) Proprietor: Vertiv S.R.L., 35028 Piove di Sacco (PD) (IT)
(72) Inventor: MASETTO, Filippo, 35010 VILLANOVA DI CAMPOSAMPIERO PD (IT); DE ZEN, Daniele, 35020 CORREZZOLA PD (IT)
(74) Representative: Modiano, Micaela Nadia

(56) References cited:
- EP-A2- 0 773 412
- WO-A1-2004/085946
- WO-A1-2008/055981
- DE-A1- 4 135 431
- US-A1- 2005 056 042

## Description

The present invention relates to an evaporation heat exchange device for air cooling for conditioning and climate control systems for server rooms and the like.

Nowadays conditioning and climate control systems are known, and are disclosed and claimed in a plurality of patent applications in the name of Emerson Network Power SRL, such as for example EPA 14189922.9, EPA 15155733.7, EPA 15194029.3, EPA 15195887.3 and EPA 15199994.3, for conditioning and climate control for server rooms, and for industrial environments in general, which are provided with evaporation means, i.e. water-based, for cooling an air stream entering or exiting the system. A heat exchange device for air conditioning and climate control system for server rooms according to the preamble of claim 1 is known from patent document US-A-2005/056042.

Such evaporation means comprise:
- an air/air exchanger,
- water dispensing means adapted to wet the cooling panel downward from above,
- means of collecting the water that descends from the cooling panel, therefore arranged below said panel,
- a recirculation pump for returning the air-cooling water from the collection means up to the dispensing means arranged above the cooling panel.

Such conditioning units and systems use an indirect/direct evaporation process as their type of cooling.

The process consists of spraying water against the stream of air in order to increase its relative humidity and therefore lower its temperature.

The physical limit that can be reached is the wet bulb temperature of the ambient air, which is a function of the humidity and of the temperature.

Differently from an evaporation tower, in which the temperature is uniform over the heat exchange surface, in such free cooling systems with evaporation cooling a cross-flow exchanger is installed, which has a marked thermal unevenness that is typical of exchangers in which the flows are not perfectly with or against the current.

It has been found experimentally that evaporation of the water is not uniform along the exchanger, but decreases with the thermal gradient.

Dividing the exchanger into a plurality of identical parts, in the direction passed through by the conditioning air flow, i.e. the air flow intended for an environment to be climate controlled, and considering the total evaporated water as 100%, it has been found experimentally that in the first parts about 30% of the cooling water emitted by the dispensing means evaporates, and in the last parts only 5-7%, i.e. the quantity necessary to bring the external air to saturation conditions.

It was then found that much of the water dispensed on the final parts of the exchanger is substantially unused, i.e. uselessly pumped and dispensed, while the initial parts of that exchanger need greater cooling in order to prevent situations of dry surfaces where calcareous encrustations can form.

Furthermore such water that is dispensed and does not evaporate obstructs the passage of air on the heat exchanger, with consequent fall in the efficiency of the machine.

The aim of the present invention is to provide an evaporation heat exchange device for air cooling for conditioning and climate control systems for server rooms and the like, which is capable of overcoming the above mentioned drawbacks of the conventional devices.

Within this aim, an object of the invention is to provide a device that is capable of improving the consumption of water and at the same time the performance levels of the machine in which it is installed.

Another object of the invention is to provide a device that simultaneously protects the integrity and the functionality of the exchanger.

This aim and these and other objects which will become better evident hereinafter are achieved by a heat exchange device for air cooling for conditioning and climate control systems for server rooms and the like, which comprises:
- an air/air heat exchanger, designed to be passed through by a primary air stream along a first trajectory from an intake region to an outflow region and by a secondary air stream along a second trajectory from a corresponding intake region to a corresponding outflow region,
- water dispensing means adapted to wet said heat exchanger downward from above,
- means of collecting the water that descends from the heat exchanger,
- a recirculation pump for returning the air-cooling water from the collection means up to the dispensing means arranged above the heat exchanger,
characterized in that said water dispensing means comprise a plurality of nozzles arranged side by side, or groups of nozzles, which are adapted to dispense flows of water with a flow-rate that decreases starting from said intake region for the primary air stream toward said outflow region of said heat exchanger.

Further characteristics and advantages of the invention will become better apparent from the description of a preferred, but not exclusive, embodiment of the device according to the invention, which is illustrated by way of non-limiting example in the accompanying drawings wherein:

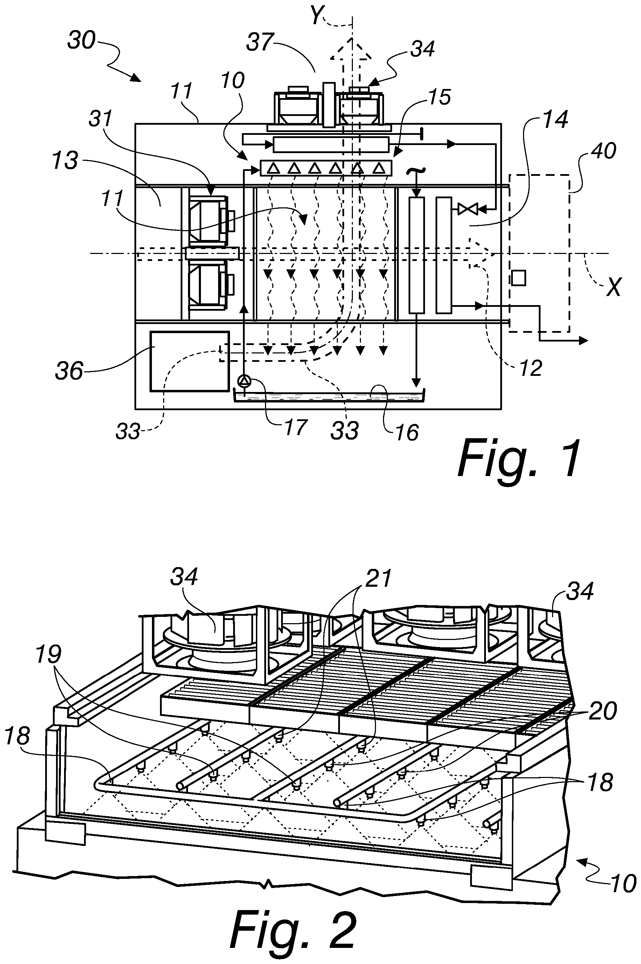

- Figure 1 is a schematic side view of a conditioning unit which comprises an evaporation cooling device according to the invention;
- Figure 2 is a cutaway perspective view of the conditioning unit which comprises an evaporation device according to the invention;
- Figure 3 is a schematic view of the operation of the device according to the invention;
- Figure 4 is a view from above of the means for dispensing water of a device according to the invention;
- Figure 5 illustrates a first variation of the dispensing means;
- Figure 6 illustrates a second variation of the dispensing means.

With reference to the figures, a heat exchange device for air cooling for conditioning and climate control systems for server rooms and the like, according to the invention, is generally designated with the reference numeral 10.

The device 10 comprises:
- an air/air heat exchanger 11, designed to be passed through by a primary air stream 12 in a main trajectory X from an intake region 13 to an outflow region 14, and by a secondary air stream 33 along a second trajectory Y from a corresponding intake region 36 to a corresponding outflow region 37,
- water dispensing means 15 adapted to wet the heat exchanger 11 downward from above,
- means 16 of collecting the water that descends from the heat exchanger 11,
- a recirculation pump 17 for returning the air-cooling water from the collection means up to the dispensing means arranged above the heat exchanger 11.

The peculiarity of the device 10 according to the invention consists in that the water dispensing means comprise a plurality of nozzles arranged side by side, or groups of nozzles, for example the rows of nozzles 18, 19, 20, 21, 22, 23, which are adapted to dispense water with a flow-rate that decreases starting from the intake region 13 toward the outflow region 14 of the exchanger 11.

The water dispensing means, for example, comprise a plurality of rows of nozzles, each row of nozzles 18, 19, 20, 21, 22, 23 comprising a plurality of nozzles, arranged side by side and in parallel in the direction going from the intake region 13 to the outflow region 14 of the cooling panel 11.

Each row of nozzles 18, 19, 20, 21, 22 and 23 comprises a plurality of nozzles, for example six nozzles.

Each row of nozzles, from the second row 19 to the last row 23 in an order that goes from the intake region 13 to the outflow region 14 of the cooling panel 11, dispenses overall a lower flow-rate of water than the preceding row.

The first row 18 therefore dispenses overall a greater flow-rate of water than the second row 19, which in turn dispenses overall a greater flow-rate of water than the third row 20.

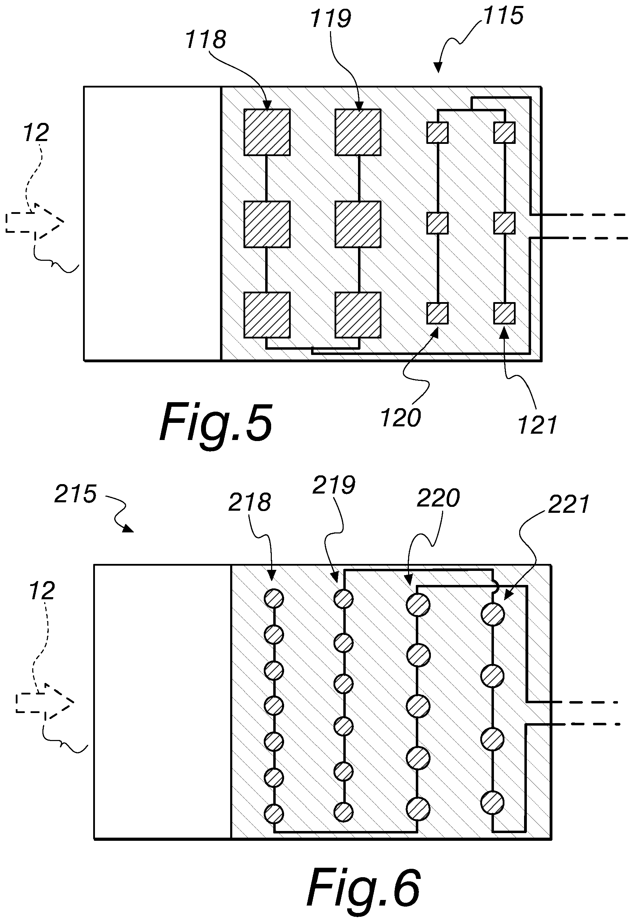

In order to obtain the different flow-rates from one row of nozzles to the next, in a first variation of embodiment of the invention, which is illustrative and non-limiting thereof and is shown schematically in Figure 5, the rows of nozzles 118, 119, 120 and 121 of the dispensing means 115 comprise an equal number of nozzles in one row with respect to the next, for example three nozzles, with such nozzles having a flow-rate that differs from row to row, i.e., for example, with the nozzles of the first row 118 and second row 119 each having a greater flow-rate than a nozzle of the third row 120 and fourth row 121.

In order to obtain the different flow-rates from one row of nozzles to the next, in a second variation of embodiment of the invention, which is illustrative and non-limiting thereof and is shown schematically in Figure 6, the rows of nozzles 218, 219, 220 and 221 comprise a different number of nozzles in one row with respect to the next, with such nozzles having the same flow-rate from row to row and within the same row.

For example a first row 218 has seven nozzles, a second row 219 has six nozzles, a third row 220 has five nozzles and a fourth row 221 has four nozzles.

In order to obtain the different flow-rates from one row of nozzles to the next, in a third variation of embodiment of the invention, which is illustrative and non-limiting thereof and is not shown for the sake of simplicity, the rows of nozzles comprise a different number of nozzles in one row with respect to the next, with such nozzles having a flow-rate that differs from row to row.

In the present embodiment, the device 10 according to the invention is shown for the purposes of example as being inserted in a conditioning unit 30, of the type with indirect free cooling, and comprises:
- an air/air heat exchanger 11, parallelepiped in shape and of known type, inside which two air streams exchange heat, a primary air stream 12, which arrives from a server room 40 and is directed toward this server room to be air-conditioned 40, and a secondary air stream 33, or process stream, which is drawn from outside.

The conditioning unit 30 comprises:
- the air/air exchanger 11,
- the water dispensing means 15 adapted to wet the exchanger 11 downward from above,
- the collection means 16,
- the recirculation pump 17,
- first fans 31 for moving the primary air stream 12,
- and second fans 34 for moving the secondary air stream 33.

It should be understood that the invention can also be implemented in a conditioning unit of the direct free cooling type.

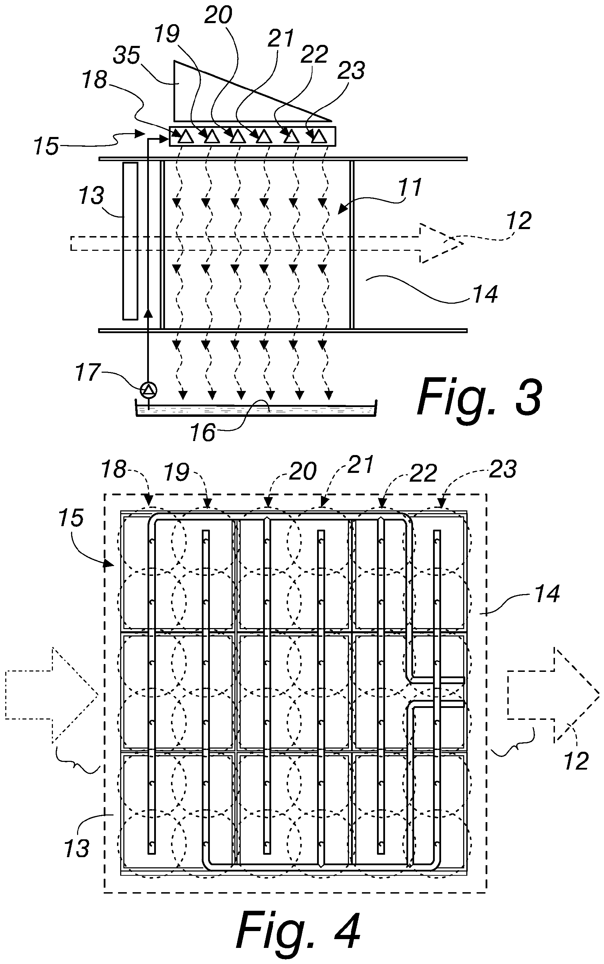

With a device 10 according to the invention, the progression of the thermal gradient 35, shown for the purposes of example in Figure 3 is exploited, such progression declining from the intake region 13 to the outflow region 14 of the heat exchanger 11, in order to optimize the flow-rate of water to be sprayed on the exchanger.

This, as described above, can be achieved by using nozzles with different flow-rates or by using a different number of nozzles from one row to the next.

In the area where there is a marked difference in temperature (the area where warm air returning from the data center enters the system), the device uses bigger nozzles or a greater number of nozzles with respect to the area where the difference is less marked, since it is found that in the first portion of the exchanger between 25% and 30% of the total water evaporates.

Therefore, by distributing the flow-rate of water proportionally to the thermal gradient present along the exchanger, a greater quantity of water is sprayed where the air is capable of absorbing more, and less where it can absorb less.

With such a device according to the invention the following advantages are obtained:
- A reduction in load losses of the exchanger, and therefore a decrease in energy consumption of the fans;
- No obstruction to the flow of air is created in the area where it absorbs less water, since less water is sprayed;
- An increase in the air flow on the process side, and therefore an increase in the performance of the conditioning unit in which the device 10 is installed;
- Since the warmest part of the exchanger is the most watered, the risk is avoided of having areas where the surface of the exchanger is no longer wetted, which can cause limescale encrustations during the most critical conditions;
- A lower flow-rate of recirculated water, with consequent reduction of the size of the pump and therefore lower energy costs;
- The range of outside conditions of operation of the unit is increased, for a given type of pump;
- Higher energy efficiency with respect to a system that has a mechanical element that moves along the exchanger in order to wet the exchange surface, since there are no moving parts, there are no dead times linked to that movement, and there is no additional electricity consumption.

In practice it has been found that the invention fully achieves the intended aim and objects.

In particular, with the invention an evaporation heat exchange device for air cooling for conditioning and climate control systems for server rooms and the like is provided that is capable of improving water consumption and at the same time the performance levels of the conditioning machine in which it is installed.

With the invention an evaporation heat exchange device for air cooling for conditioning and climate control systems for server rooms and the like is provided, that simultaneously protects the integrity and the functionality of the exchanger.

In fact, with the invention a device is provided that offers lower energy consumption and therefore less absorption of energy by the fans and pumps of the conditioning unit of which it is part.

What is more, with the invention a device is provided that is found to be efficient in the entire wet operation range and not only in the design phase.

Furthermore, with the invention a device is provided that makes the conditioning unit in which it is inserted more flexible in terms of possible conditions of use.

Furthermore, with the invention a device is provided that diminishes the risk of forming encrustations on the exchanger.

Furthermore, with the invention a device is provided that requires less recirculation of water and therefore less consumption of water owing to evaporation which does not produce any cooling effect.

The invention thus conceived is susceptible of numerous modifications and variations, all of which are within the scope of the appended claims. Moreover, all the details may be substituted by other, technically equivalent elements.

In practice the components and the materials employed, provided they are compatible with the specific use, and the contingent dimensions and shapes, may be any according to requirements and to the state of the art.

The disclosures in Italian Patent Application No. 102016000033465 (UA2016A002214) from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A heat exchange device (10) for air cooling for conditioning and climate control systems for server rooms and the like, which comprises:
- an air/air heat exchanger (11), designed to be passed through by a primary air stream (12) along a first trajectory (X) from an intake region (13) to an outflow region (14) and by a secondary air stream (33) along a second trajectory (Y) from a corresponding intake region (36) to a corresponding outflow region (37),
- water dispensing means (15) adapted to wet said heat exchanger (11) downward from above,
- means (16) of collecting the water that descends from the heat exchanger (11),
- a recirculation pump (17) for returning the air-cooling water from the collection means up to the dispensing means arranged above the heat exchanger (11),
being **characterized in that** said water dispensing means (15) comprise a plurality of nozzles arranged side by side, or rows of nozzles (18, 19, 20, 21, 22, 23), which are adapted to dispense water with a flow-rate that decreases starting from said intake region (13) for the primary air stream (12) toward said outflow region (14) of said heat exchanger (11).

2. The device according to claim 1, **characterized in that** said water dispensing means comprise a plurality of rows of nozzles, each row of nozzles (18, 19, 20, 21, 22, 23) comprising a plurality of nozzles and being arranged side by side and in parallel in a direction going from the intake region (13) to the outflow region (14) of the heat exchanger (11).

3. The device according to one or more of the preceding claims, **characterized in that** each row of nozzles, from a second row (19) to a last row (23) in an order that goes from the intake region (13) to the outflow region (14) of the cooling panel (11), dispenses overall a lower flow-rate of water than the preceding row.

4. The device according to one or more of the preceding claims, **characterized in that** it comprises rows of nozzles (118, 119, 120, 121), of the dispensing means (115), which comprise an equal number of nozzles in one row with respect to the next, with said nozzles having a flow-rate that differs from row to row.

5. The device according to one or more of the preceding claims, **characterized in that** it comprises rows of nozzles (218, 219, 220, 221), of the dispensing means (215), which comprise a different number of nozzles in one row with respect to the next, said nozzles having the same flow-rate from row to row and within the same row.

6. The device according to one or more of the preceding claims, **characterized in that** it comprises rows of nozzles that comprise a different number of nozzles in one row with respect to the next, said nozzles having a flow-rate that differs from row to row.

## Patentansprüche

1. Eine Wärmetauschvorrichtung (10) zur Luftkühlung für Konditionierungs- und Klimakontrollsysteme für Serverräume und dergleichen, die Folgendes umfasst:
- einen Luft-Luft-Wärmetauscher (11), konstruiert, um von einem primären Luftstrom (12) entlang einer ersten Trajektorie (X) von einem Einlassbereich (13) zu einem Auslassbereich (14) und von einem sekundären Luftstrom (33) entlang einer zweiten Trajektorie (Y) von einem entsprechenden Einlassbereich (36) zu einem entsprechenden Auslassbereich (37) durchströmt zu werden,
- Wasserabgabemittel (15), ausgebildet, um den Wärmetauscher (11) von oben nach unten zu befeuchten,
- Mittel (16) zum Sammeln des Wassers, das vom Wärmetauscher (11) herabfließt,
- eine Umlaufpumpe (17) zum Rückführen des Luftkühlungswassers von den Sammlungsmitteln zu den Abgabemitteln, die über dem Wärmetauscher (11) angeordnet sind,
**dadurch gekennzeichnet, dass** die Wasserabgabemittel (15) eine Vielzahl nebeneinander angeordneter Düsen, oder Reihen von Düsen (18, 19, 20, 21, 22, 23) umfassen, die ausgebildet sind, um Wasser mit einer Strömungsrate abzugeben, die von dem Einlassbereich (13) für den primären Luftstrom (12) zu dem Auslassbereich (14) des Wärmetauschers (11) hin abnimmt.

2. Die Vorrichtung gemäß Anspruch 1, **dadurch gekennzeichnet, dass** die Wasserabgabemittel eine Vielzahl von Reihen von Düsen umfassen, wobei jede Reihe von Düsen (18, 19, 20, 21, 22, 23) eine Vielzahl von Düsen umfasst, die nebeneinander und parallel in eine Richtung angeordnet sind, welche vom Einlassbereich (13) zum Auslassbereich (14) des Wärmetauschers (11) führt.

3. Die Vorrichtung gemäß einem oder mehreren der obigen Ansprüche, **dadurch gekennzeichnet, dass** jede Reihe von Düsen, von einer zweiten Reihe (19) bis zu einer letzten Reihe (23) in einer Reihenfolge, die vom Einlassbereich (13) zum Auslassbereich (14) des Wärmetauschers (11) führt, insgesamt Wasser mit einer niedrigeren Strömungsrate abgibt als die vorhergehende Reihe.

4. Die Vorrichtung gemäß einem oder mehreren der obigen Ansprüche, **dadurch gekennzeichnet, dass** sie Reihen von Düsen (118, 119, 120, 121) der Abgabemittel (115) umfasst, die in einer Reihe eine gleiche Anzahl von Düsen umfassen wie in der nächsten, wobei die Düsen eine Strömungsrate haben, die sich von einer Reihe zur anderen unterscheidet.

5. Die Vorrichtung gemäß einem oder mehreren der obigen Ansprüche, **dadurch gekennzeichnet, dass** sie Reihen von Düsen (218, 219, 220, 221) der Abgabemittel (215) umfasst, die in einer Reihe eine andere Anzahl von Düsen umfassen als in der nächsten, wobei die Düsen von einer Reihe zur anderen und innerhalb einer Reihe dieselbe Strömungsrate haben.

6. Die Vorrichtung gemäß einem oder mehreren der obigen Ansprüche, **dadurch gekennzeichnet, dass** sie Reihen von Düsen umfasst, die eine andere Anzahl von Düsen in einer Reihe als in der nächsten umfassen, wobei die Düsen eine Strömungsrate haben, die sich von einer Reihe zur anderen unterscheidet.

## Revendications

1. Dispositif d'échange de chaleur (10) pour un refroidissement d'air pour des systèmes de conditionnement et de commande de climatisation pour des salles de serveurs et analogues, qui comporte :
- un échangeur de chaleur air/air (11), conçu pour être traversé par un flux d'air primaire (12) le long d'une première trajectoire (X) d'une zone d'admission (13) à une zone d'écoulement de sortie (14) et par un flux d'air secondaire (33) le long d'une seconde trajectoire (Y) d'une zone d'admission (36) correspondante à une zone d'écoulement de sortie (37) correspondante,
- des moyens de distribution d'eau (15) adaptés pour humidifier ledit échangeur de chaleur (11) vers le bas à partir du dessus,
- des moyens (16) pour collecter l'eau qui descend de l'échangeur de chaleur (11),
- une pompe de recirculation (17) pour renvoyer l'eau de refroidissement d'air à partir des moyens de collecte jusqu'aux moyens de distribution agencés au-dessus de l'échangeur de chaleur (11),
**caractérisé en ce que** lesdits moyens de distribution d'eau (15) comportent une pluralité de buses agencées côte à côte, ou des rangées de buses (18, 19, 20, 21, 22, 23), qui sont adaptées pour distribuer de l'eau avec un débit qui diminue à partir de ladite zone d'admission (13) pour l'écoulement d'air primaire (12) vers ladite zone d'écoulement de sortie (14) dudit échangeur de chaleur (11).

2. Dispositif selon la revendication 1, **caractérisé en ce que** lesdits moyens de distribution d'eau comportent une pluralité de rangées de buses, chaque rangée de buses (18, 19, 20, 21, 22, 23) comportant une pluralité de buses et étant agencées côte à côte et parallèlement dans une direction de ladite zone d'admission (13) jusqu'à la zone d'écoulement de sortie (14) de l'échangeur de chaleur (11).

3. Dispositif selon une ou plusieurs des revendications précédentes, **caractérisé en ce que** chaque rangée de buses, à partir d'une deuxième rangée (19) jusqu'à une dernière rangée (23) dans un ordre qui va de la zone d'admission (13) jusqu'à la zone d'écoulement de sortie (14) du panneau de refroidissement (11), distribue globalement un débit d'eau inférieur à la rangée précédente.

4. Dispositif selon une ou plusieurs des revendications précédentes, **caractérisé en ce qu'**il comporte des rangées de buses (118, 119, 120, 121), des moyens de distribution (115), qui comportent un nombre égal de buses dans une première rangée par rapport à la suivante, lesdites buses ayant un débit qui diffère d'une rangée à l'autre.

5. Dispositif selon une ou plusieurs des revendications précédentes, **caractérisé en ce qu'**il comporte des rangées de buses (218, 219, 220, 221), des moyens de distribution (215), qui comportent un nombre différent de buses dans une première rangée par rapport à la suivante, lesdites buses ayant le même débit d'une rangée à l'autre et dans la même rangée.

6. Dispositif selon une ou plusieurs des revendications précédentes, **caractérisé en ce qu'**il comporte des rangées de buses qui comportent un nombre différent de buses dans une première rangée par rapport à la suivante, lesdites buses ayant un débit qui diffère d'une rangée à l'autre.
